# EUROPEAN PATENT APPLICATION

(11) **EP 4 726 554 A1**
(43) Date of publication of application: **15.04.2026**
(21) Application number: 23953539.6
(22) Date of filing: 27.09.2023
(51) Int. Cl.: G06F 11/22

(54) **FAULT DETECTION METHOD AND APPARATUS AND INTELLIGENT DRIVING DEVICE**

(71) Applicant: Shenzhen Yinwang Intelligent Technologies Co., Ltd., Shenzhen, Guangdong 518110 (CN)
(72) Inventor: CAO, Jianlong, Shenzhen, Guangdong 518129 (CN)
(74) Representative: Maiwald GmbH
(86) International application number: PCT/CN2023/122214
(87) International publication number: WO 2025/065386

(57) **Abstract**

A fault detection method and apparatus, and an intelligent driving device are disclosed. The method includes: obtaining information about a first test pattern, where the first test pattern is a to-be-run test pattern, and the first test pattern is used to detect a fault of an integrated circuit; and adjusting, to a target frequency based on the first test pattern, a running frequency of a processor configured to run the first test pattern, so that when the processor runs the first test pattern at the target frequency, a running speed of the first test pattern can be increased or power consumption required for running the first test pattern can be reduced. The technical solutions of this application may be applied to the intelligent driving device, to adjust a running frequency of a processor based on an STL test pattern, thereby achieving a balance between a fault detection speed and required power consumption.

## Description

### TECHNICAL FIELD

This application relates to the field of computer technologies, and more specifically, to a fault detection method and apparatus, and an intelligent driving device.

### BACKGROUND

In the computer field, a random hardware fault may occur in a fault detection apparatus, for example, a permanent fault caused by a short circuit or an open circuit in an integrated circuit, or a temporary fault like bit flipping caused by exposure to natural radiation or particle collision. In some application fields with a high safety requirement, for example, in the field of intelligent driving, to ensure functional safety, a fault detection mechanism may be provided for a processor, to detect a hardware fault and ensure that a safe operation is performed when the hardware fault occurs.

However, running of a real-time service may affect a fault detection speed and required power consumption. Therefore, how to balance the detection speed and the power consumption required for detection in a fault detection process becomes an urgent problem to be resolved.

### SUMMARY

This application provides a fault detection method and apparatus, and an intelligent driving device, to adjust a running frequency of a processor based on an STL test pattern, thereby achieving a balance between a fault detection speed and required power consumption.

According to a first aspect, a fault detection method is provided. The method may be performed by an intelligent driving device, for example, performed by a computing platform in the intelligent driving device, or performed by a chip or a processor in the intelligent driving device. The intelligent driving device may be a vehicle.

The method includes: obtaining information about a first test pattern, where the first test pattern is a to-be-run test pattern, and the first test pattern is used to detect a fault of a first integrated circuit; and adjusting a running frequency of a first processor to a first target frequency based on the first test pattern, where the first processor is configured to run the first test pattern.

In the foregoing technical solution, when a fault detection process runs, the running frequency of the processor can be adjusted based on the to-be-run test pattern. In this way, when a running frequency of a processor used by a process that runs before running of the first test pattern is excessively high, the running frequency of the processor can be reduced, to reduce power consumption. When the running frequency of the processor used by the process that runs before running of the first test pattern is excessively low, the running frequency of the processor can be increased, to increase a running speed of the first test pattern. When a plurality of test patterns need to be run for a target task, and running frequencies of processors required by the plurality of test patterns are different, for example, the plurality of test patterns include at least one computing-intensive test pattern and at least one memory-intensive test pattern, based on the foregoing technical solution, a running speed of the computing-intensive test pattern can be improved, and power consumption required for running the memory-intensive test pattern is reduced without reducing a running speed of the memory-intensive test pattern, to balance a fault detection speed and required power consumption.

With reference to the first aspect, in some implementations of the first aspect, the first target frequency is determined based on a type of the first test pattern, and the type of the first test pattern includes a computing-intensive type or a memory-intensive type.

In the foregoing technical solution, the first target frequency can be determined based on the type of the first test pattern, so that power consumption required for monitoring a running status of the first test pattern can be reduced, and computing power required for modifying or updating the first target frequency based on the running status of the first test pattern can be reduced.

With reference to the first aspect, in some implementations of the first aspect, the first target frequency is determined based on a running frequency at which the first processor runs the first test pattern last time and running duration of the first test pattern.

In the foregoing technical solution, the first target frequency can be modified or updated based on the running status of the first test pattern, so that when the first processor runs the first test pattern at the first target frequency, better acceleration effect or better power consumption reduction effect can be achieved.

With reference to the first aspect, in some implementations of the first aspect, the first test pattern is associated with a first virtual machine, and the method further includes: after the running frequency of the first processor is adjusted to the first target frequency, updating frequency information of a virtual machine manager, where the frequency information indicates a current running frequency of the first processor, and the virtual machine manager is configured to manage one or more virtual machines including the first virtual machine.

In the foregoing technical solution, after the running frequency of the first processor is adjusted, the frequency information of the virtual machine manager is updated, so that a case in which a modification made by the virtual machine to the frequency of the processor cannot be synchronized to the virtual machine manager can be avoided. This helps improve robustness of a fault detection system.

With reference to the first aspect, in some implementations of the first aspect, the method further includes: obtaining frequency optimization information, where the frequency optimization information indicates a target frequency at which a processor correspondingly runs each of one or more test patterns, and the one or more test patterns include the first test pattern; and determining the first target frequency based on the first test pattern and the frequency optimization information.

With reference to the first aspect, in some implementations of the first aspect, the method further includes: running the first test pattern when the running frequency of the first processor is adjusted.

In the foregoing technical solution, the test pattern is run while the running frequency of the processor is adjusted. This helps reduce impact of duration required for frequency conversion on the fault detection speed, further improve the fault detection speed, and further reduce impact of the fault detection process on real-time performance of a service layer task.

With reference to the first aspect, in some implementations of the first aspect, the method further includes: before the running frequency of the first processor is adjusted to the first target frequency, performing first context switch, where the first context switch is used for running of the first test pattern.

In the foregoing technical solution, frequency conversion and context switch are simultaneously performed. This helps reduce duration required in a frequency adjustment process, and helps further improve the fault detection speed.

With reference to the first aspect, in some implementations of the first aspect, the method further includes: after running of the first test pattern ends and before the running frequency of the first processor is adjusted to a second target frequency, performing second context switch, where the second context switch is used for running of a first process, and the second target frequency is a target frequency at which the first processor correspondingly runs the first process.

With reference to the first aspect, in some implementations of the first aspect, when the first test pattern is associated with a trusted execution environment TEE, before performing first context switch, the method further includes: switching from a rich execution environment REE to the TEE.

In the foregoing technical solution, in a scenario in which world switch is required, world switch (and context switch) and frequency conversion are simultaneously performed. This helps reduce the duration required in the frequency adjustment process, and helps further improve the fault detection speed.

According to a second aspect, a fault detection apparatus is provided. The apparatus includes: an obtaining unit, configured to obtain information about a first test pattern, where the first test pattern is a to-be-run test pattern, and the first test pattern is used to detect a fault of a first integrated circuit; and a first processing unit, configured to adjust a running frequency of a first processor to a first target frequency based on the first test pattern, where the first processor is configured to run the first test pattern.

With reference to the second aspect, in some implementations of the second aspect, the first target frequency is determined based on a type of the first test pattern, and the type of the first test pattern includes a computing-intensive type or a memory-intensive type.

With reference to the second aspect, in some implementations of the second aspect, the first target frequency is determined based on a running frequency at which the first processor runs the first test pattern last time and running duration of the first test pattern.

With reference to the second aspect, in some implementations of the second aspect, the first test pattern is associated with a first virtual machine, and the apparatus further includes a second processing unit, configured to: after the running frequency of the first processor is adjusted to the first target frequency, update frequency information of a virtual machine manager, where the frequency information indicates a current running frequency of the first processor, and the virtual machine manager is configured to manage one or more virtual machines including the first virtual machine.

With reference to the second aspect, in some implementations of the second aspect, the obtaining unit is further configured to obtain frequency optimization information, where the frequency optimization information indicates a target frequency at which a processor correspondingly runs each of one or more test patterns, and the one or more test patterns include the first test pattern; and the first processing unit is configured to determine the first target frequency based on the first test pattern and the frequency optimization information.

With reference to the second aspect, in some implementations of the second aspect, the first processing unit is further configured to run the first test pattern when the running frequency of the first processor is adjusted.

With reference to the second aspect, in some implementations of the second aspect, the first processing unit is further configured to: before the running frequency of the first processor is adjusted to the first target frequency, perform first context switch, where the first context switch is used for running of the first test pattern.

With reference to the second aspect, in some implementations of the second aspect, the first processing unit is further configured to: after running of the first test pattern ends and before the running frequency of the first processor is adjusted to a second target frequency, perform second context switch, where the second context switch is used for running of a first process, and the second target frequency is a target frequency at which the first processor correspondingly runs the first process.

With reference to the second aspect, in some implementations of the second aspect, when the first test pattern is associated with a trusted execution environment TEE, before performing first context switch, the apparatus further includes a third processing unit, configured to switch from a rich execution environment REE to the TEE.

According to a third aspect, a fault detection apparatus is provided. The apparatus includes: a memory, configured to store a computer program, and a processor, configured to execute the computer program stored in the memory, to enable the apparatus to perform the method according to any possible implementation of the first aspect.

According to a fourth aspect, a computing platform is provided. The computing platform includes the apparatus according to any possible implementation of the second aspect or the third aspect.

According to a fifth aspect, an intelligent driving device is provided. The intelligent driving device includes the apparatus according to any possible implementation of the second aspect or the third aspect. Alternatively, the intelligent driving device includes the apparatus according to any possible implementation of the fourth aspect.

With reference to the fifth aspect, in some implementations of the fifth aspect, the intelligent driving device is a vehicle.

According to a sixth aspect, a computer program product is provided. The computer program product includes computer program code. When the computer program code is run on a computer, the computer is enabled to perform the method according to any possible implementation of the first aspect.

It should be noted that all or a part of the computer program code may be stored in a first storage medium. The first storage medium may be encapsulated together with a processor, or may be encapsulated separately from a processor.

According to a seventh aspect, a computer-readable medium is provided. The computer-readable medium stores instructions, and when the instructions are executed by a processor, the processor is enabled to implement the method according to any possible implementation of the first aspect.

According to an eighth aspect, a chip is provided. The chip includes a circuit, and the circuit is configured to perform the method according to any possible implementation of the first aspect.

### BRIEF DESCRIPTION OF DRAWINGS

FIG. 1 is a diagram of a relationship between running of a fault detection process and running of a service layer task;
FIG. 2(a) to FIG. 2(d) are block diagrams of a fault detection system according to an embodiment of this application;
FIG. 3 is a schematic flowchart of a fault detection method according to an embodiment of this application;
FIG. 4 is another block diagram of a fault detection method according to an embodiment of this application;
FIG. 5 is another schematic flowchart of a fault detection method according to an embodiment of this application;
FIG. 6 is a diagram of an application scenario of a fault detection method according to an embodiment of this application;
FIG. 7 is a diagram of another application scenario of a fault detection method according to an embodiment of this application;
FIG. 8 is a block diagram of a fault detection apparatus according to an embodiment of this application;
FIG. 9 is another block diagram of a fault detection apparatus according to an embodiment of this application; and
FIG. 10 is a functional diagram of an intelligent driving device according to an embodiment of this application.

### DESCRIPTION OF EMBODIMENTS

To facilitate understanding of solutions in embodiments of this application, concepts in this application are described first.
1. Autonomous driving operating system (referred to as an autonomous driving system below): The autonomous driving system is, for example, an operating system based on a portable operating system interface (portable operating system interface, POSIX) standard, is an operating system applicable to high-performance computing and high-bandwidth communication that are required by autonomous driving, and provides functions such as environment sensing, sensor fusion, and route planning of an intelligent driving device.
2. Autonomous driving service (referred to as a service below): In the autonomous driving system, the service is usually a set of processes and/or threads that are encapsulated by using communication middleware and that have a specific autonomous driving function. The communication middleware may be a robot operating system (robot operating system, ROS), an automotive open system architecture communication management (automotive open system architecture communication management, AUTOSAR CM) module, or the like. The autonomous driving function may include functions such as environment sensing, sensor fusion, and route planning of the intelligent driving device.
3. Process (process): The process is a running activity of a program in a computer about a data set, is a basic unit for a system to allocate and schedule resources, and is a basis of an operating system structure. In an early process-oriented computer architecture, a process is a basic execution entity of a program. In a modern thread-oriented computer architecture, a process is a container for threads. The program is a description of instructions, data, and an organizational form thereof. The process is a program entity. A process is identified by a process identifier.
4. Thread: The thread is a minimum unit that an operating system can compute and schedule. The thread is included in the process and is an actual operating unit of the process. One thread is one control flow in a single order in a process. One process may have a plurality of concurrent threads, and the threads execute different tasks in parallel. The thread may be identified by a thread identifier.
5. Task: The task is an abstract concept of a time segment of the thread. The task one-to-one corresponds to the time segment of the thread, that is, one time segment of one thread is one task.
   In conclusion, one or more threads may form one process, and time segments (namely, one or more tasks) of one or more processes may form one service.
6. Central processing unit (central processing unit, CPU)-intensive task: The central processing unit-intensive task is also referred to as a computing-intensive task, is a strategy for executing tasks on the computer. When the system runs a task, memory read/write can be completed within a short period of time, and there is almost no blocking time (namely, real time for waiting for memory read/write). However, running of the task requires a CPU to perform a large amount of computing, which consumes CPU resources. Therefore, CPU load is excessively high for a long time.
7. Memory-intensive task: The memory-intensive task is also referred to as an input/output (input/output, I/O)-intensive task, and is another strategy for executing tasks on the computer. When the system runs a task, CPU consumption is low, and most of time in a task running process is consumed for waiting for a memory read/write operation to be completed.
8. Functional safety: The functional safety means that there is no unacceptable risk caused by an electronic system fault, and an ultimate goal of functional safety is to prevent casualties or huge property losses caused by the electronic system (referred to as a system below) fault.
9. Software-based built-in self-test (software-based built-in self-test, SBIST): The software-based built-in self-test means to detect a function logic failure other than a memory by using a specific software test library (software test library, STL) test pattern (test pattern) and a software-based online error detection technology. When the STL test pattern is run, a register corresponding to the test pattern can be tested. The test pattern may be a string of binary codes including logic 1 and logic 0, and the logic 1 and the logic 0 respectively indicate a driving high level and a driving low level that are applied to a circuit. An essence of performing a test by using the test pattern is to input the binary code into a to-be-tested circuit, and then detect, at an output end of the circuit, whether an output signal is consistent with expected graphics data. If the output signal is consistent with the expected graphics data, it is determined that a circuit function is normal; or if the output signal is inconsistent with the expected graphics data, it is determined that an error occurs in the circuit.
10. Dynamic voltage and frequency scaling (dynamic voltage and frequency scaling, DVFS): The dynamic voltage and frequency scaling is a technology that balances performance and power consumption by dynamically adjusting a voltage and a frequency of a processor. A principle is as follows: A voltage and a frequency of a processor are dynamically adjusted based on load of the processor, to meet balance between a performance requirement and a power consumption requirement of the processor. When the load of the processor is low, the frequency and the voltage of the processor are reduced to reduce power consumption. When the load of the processor is high, the frequency and the voltage of the processor are increased to provide better performance.
11. Context switch: The context switch means that a kernel switches a process or a thread on the CPU, that is, stores a current status, namely, all content in a CPU register and a program counter, of a running task, loads a new task to be run to the CPU register and the program counter, and starts to run the new task. Context may be understood as a status of a task in the CPU.

As described above, in the computer field, a random hardware fault may occur in a fault detection apparatus, for example, a permanent fault caused by a short circuit or an open circuit in an integrated circuit, or a temporary fault like bit flipping caused by exposure to natural radiation or particle collision. Therefore, to ensure security of a computer system, faults that have occurred need to be detected and dealt with in time.

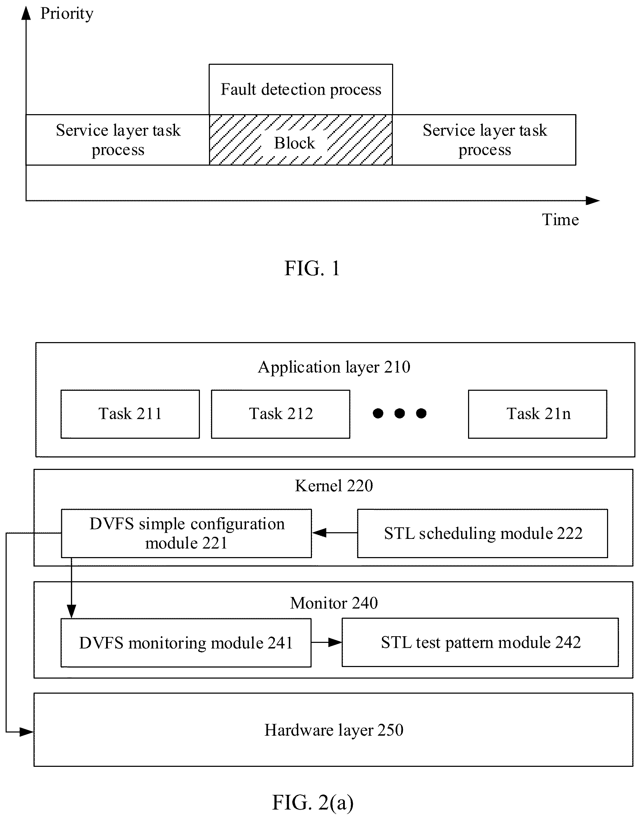

In a current technical background, the STL-based SBIST technology is usually used. When a service layer task is run, an STL test pattern corresponding to the service layer task may be run, to detect whether a fault occurs in an integrated circuit used to execute the service layer task. Usually, a running priority of a fault detection process is higher than a running priority of a service layer task process. Therefore, the fault detection process like the STL test pattern blocks the service layer task process, as shown in FIG. 1. Consequently, duration required for completing the service layer task process is increased. In other words, running of the STL test pattern increases the duration for running the service layer task. In some application fields with a high safety requirement, for example, the autonomous driving field, the running of the STL test pattern may affect real-time performance of a task related to autonomous driving, and further affect driving safety.

In addition, the service layer task process may also affect running duration of the fault detection process. In the existing computer system, the frequency of the processor can be dynamically adjusted by using the DVFS technology. However, in the DVFS technology, only the running frequency the processor corresponding to the service layer task can be sensed, and a running frequency a processor corresponding to the STL test pattern cannot be sensed or adjusted. In other words, in the DVFS technology, only the frequency of the processor of the service layer task can be adjusted. After the running frequency the processor is adjusted based on the service layer task, when the STL test pattern associated with the service layer task is run, the processor runs the STL test pattern at the running frequency adjusted based on the service layer task. The STL test pattern associated with the service layer task means that the STL test pattern is used to perform fault detection on the integrated circuit that executes the service layer task.

In the foregoing scenario, if a service layer task is a memory-intensive task, when running the service layer task, the processor selects a low running frequency to reduce power consumption. If a type of an STL test pattern associated with the service layer task is a computing-intensive type, because a running frequency of a processor cannot be adjusted for the STL test pattern by using the DVFS technology, the processor still runs the STL test pattern at a low running frequency. As a result, running of the STL test pattern takes a long time, and real-time performance of the service layer task is affected. If a service layer task is a computing-intensive task, when running the service layer task, the processor selects a high running frequency to increase a processing speed. If a type of an STL test pattern associated with the service layer task is a memory-intensive type, because a running frequency of a processor cannot be adjusted for the STL test pattern by using the DVFS technology, the processor still runs the STL test pattern at a high running frequency. However, it can be learned from a feature of the memory-intensive type that such a high running frequency does not accelerate a running speed of the STL test pattern associated with the service layer task, but consumes unnecessary power consumption.

In view of this, this application provides a fault detection method and apparatus, and an intelligent driving device, to adjust a running frequency of a processor based on an STL test pattern, thereby achieving a balance between a fault detection speed and required power consumption. During frequency adjustment, clock frequency switch and context switch are synchronously performed. This helps reduce duration required for running the STL test pattern, and further improves real-time performance for running a service layer task.

The following describes technical solutions of this application with reference to accompanying drawings.

FIG. 2(a) to FIG. 2(d) are block diagrams of a fault detection system according to an embodiment of this application.

As shown in FIG. 2(a), the fault detection system includes a service layer 210, a kernel 220, a monitor (monitor) 240, and a hardware layer 250.

The service layer 210 may include one or more tasks such as one or more of a task 211, a task 212, and a task 21n. The one or more tasks may form one or more services. If the fault detection system is disposed in an autonomous driving vehicle, the one or more services may be services related to autonomous driving, for example, services such as obstacle sensing, target recognition, intelligent driving device positioning, route planning, and driver monitoring/reminding. In some implementations, one service may be one application (application).

The kernel 220 includes parts, in an operating system, that are configured to manage a memory, a file, a peripheral, and system resources. The kernel 220 may interact with hardware at the hardware layer, run a process based on the task at the service layer 210, provide inter-process communication, and provide CPU time slice management, interruption, memory management, I/O management, and the like. The kernel 220 includes a DVFS simple configuration module 221 and an STL scheduling module 222. The DVFS simple configuration module 221 is configured to perform frequency conversion preparation work, that is, perform enabling of DVFS and all previous work. For example, the DVFS simple configuration module 221 may configure a target frequency for a target processor based on a to-be-run STL test pattern, and enable the DVFS. After the DVFS simple configuration module 221 enables the DVFS, a frequency governor (for example, a cpufreq governor) adjusts a frequency of the target processor at the hardware layer 250 to the target frequency. The STL scheduling module 222 may be disposed in a kernel scheduler, and may adjust the frequency of the target processor by invoking the DVFS simple configuration module 221, and control running of the to-be-run STL test pattern. The target processor is configured to run the to-be-run STL test pattern.

In a specific implementation process, the STL scheduling module 222 may determine the target frequency based on the to-be-run STL test pattern and the STL frequency optimization information, and the STL scheduling module 222 invokes the DVFS simple configuration module 221, so that the DVFS simple configuration module 221 performs the preparation work for adjusting the frequency of the target processor to the target frequency, for example, configuring the target frequency, configuring a frequency adjustment step, and enabling the DVFS. For example, the STL frequency optimization information records recommended running frequencies corresponding to one or more STL test patterns, and the recommended running frequency is a running frequency of a processor that can improve running efficiency of the STL test pattern and/or reduce power consumption required for running the STL test pattern. The STL scheduling module 222 may determine a recommended running frequency of the to-be-run test pattern as the target frequency. For example, the STL frequency optimization information may be in a form of a file (file), may be in a form of a table, or may be in another form.

For example, when or after the DVFS simple configuration module 221 enables the DVFS, the STL scheduling module 222 performs context switch to control running of the to-be-run STL test pattern. For another example, when the STL scheduling module 222 invokes the DVFS simple configuration module 221 to perform frequency adjustment, when or after the DVFS simple configuration module 221 enables the DVFS, context switch is automatically performed to control running of the to-be-run STL test pattern. For still another example, when performing context switch to control running of the to-be-run STL test pattern, the STL scheduling module 222 invokes the DVFS simple configuration module 221, to adjust the frequency of the target processor to the target frequency.

The monitor 240 is configured to: manage a thread, and monitor and record a running process. The monitor 240 includes a DVFS monitoring module 241 and an STL test pattern module 242. The STL test pattern module 242 includes one or more STL test patterns, and the one or more STL test patterns include a running STL test pattern. For example, the one or more STL test patterns may be used to detect whether a fault occurs in an integrated circuit, or the one or more STL test patterns may be used to detect whether a fault occurs in a plurality of integrated circuits. The DVFS monitoring module 241 monitors a current running status, obtains a current running frequency of a processor and running duration of a running STL test pattern, and updates the STL frequency optimization information offline based on the current running frequency and the running duration.

In some implementations, the STL test pattern module 242 may include one or more scheduling tables, each scheduling table is associated with a service layer task, and each scheduling table includes one or more test patterns. That each scheduling table is associated with a service layer task may be understood as that a test pattern in the scheduling table is used to detect whether a fault occurs in an integrated circuit that executes the service layer task. The scheduling table may be generated based on the service layer task, or may be preset in the system.

The hardware layer 250 may provide a basic hardware platform for the kernel 220. The hardware layer 250 may include a processor, a memory, a network interface card, and a storage. The processor provides computing power resources for the kernel 220, and the processor includes the target processor. The memory provides memory resources for the kernel 220. The network interface card provides network communication resources for the kernel 220. The storage provides general-purpose storage resources for the kernel 220. If the fault detection system is disposed in the autonomous driving vehicle, the hardware layer 250 may further include a sensor, and the sensor provides sensing data resources for the kernel 220.

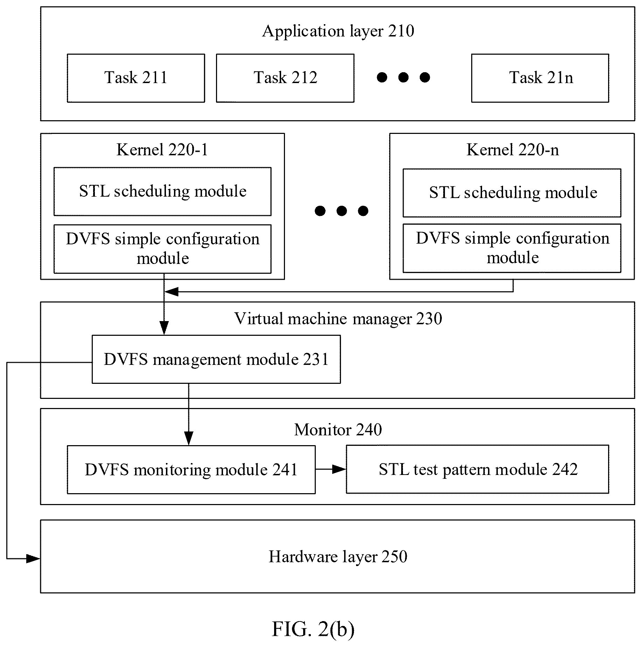

In some scenarios in which virtualization is required, for example, when different types of operating systems need to run on a same computing platform, the fault detection system may further include a virtual machine manager 230, which is specifically shown in FIG. 2(b).

The virtual machine manager 230 is configured to create or run virtual machines, to provide heterogeneous operating systems with a capability of accessing hardware resources on a same hardware platform. The virtual machine is a virtual instance of a computer, and may perform almost the same functions as the computer, including running an application and an operating system. The virtual machine is run on a physical machine and accesses computing resources via the virtual machine manager 230. The virtual machine manager 230 abstracts the resources of the physical machine into a resource pool in which the resources can be pre-allocated and distributed on demand, so that a plurality of virtual machines can be run on the same physical machine.

For example, each virtual machine may include a virtual kernel, and each virtual kernel includes a DVFS simple configuration module and an STL scheduling module. For example, the virtual kernel may include a kernel 220-1 and a kernel 220-n (n is an integer greater than or equal to 2) shown in FIG. 2(b). For functions of the DVFS simple configuration module and the STL scheduling module in the virtual kernel, respectively refer to the related descriptions of the DVFS simple configuration module 221 and the STL scheduling module 222. Details are not described herein again.

The virtual machine manager 230 includes a DVFS management module 231. The DVFS management module 231 is configured to: after a virtual machine adjusts a frequency of a processor, update, in a DVFS configuration file, a frequency of the processor to the current running frequency of the processor, to avoid a case in which a modification made by the virtual machine to the frequency of the processor cannot be synchronized to the virtual machine manager 230.

In some implementations, the DVFS management module 231 may further perform arbitration processing. For example, in a virtualization scenario, the DVFS simple configuration module (for example, before the DVFS is enabled) in the virtual machine may generate a frequency adjustment request based on a target frequency. The frequency adjustment request is used to request to adjust a frequency of a target processor to the target frequency. Two or more virtual machines may request to adjust a same processor to different frequencies. When frequency adjustment requests of the two or more virtual machines conflict, the DVFS management module 231 may perform arbitration processing, for example, respond to a frequency adjustment request with a higher priority based on priorities of the frequency adjustment requests. For example, when the frequency adjustment request is generated based on a to-be-run STL test pattern, the priority of the frequency adjustment request may be determined based on a priority of the STL test pattern, or the priority of the frequency adjustment request may be determined based on a priority of a service layer task corresponding to the STL test pattern.

In some implementations, the DVFS management module 231 may further determine, based on the frequency adjustment request, whether to perform frequency adjustment. For example, when receiving a frequency adjustment request of a virtual machine, the DVFS management module 231 may determine, based on a target frequency of a target processor requested by the frequency adjustment request and a frequency of the target processor recorded in the DVFS configuration file, whether to perform frequency adjustment. For example, when the frequency of the target processor recorded in the DVFS configuration file is the same as the target frequency, frequency adjustment does not need to be performed; or when the frequency of the target processor recorded in the DVFS configuration file is different from the target frequency, the frequency of the target processor is controlled to be adjusted to the target frequency.

For example, that the DVFS management module 231 controls to adjust the frequency of the target processor to the target frequency may include: The DVFS management module 231 sends indication information to the frequency governor, where the indication information indicates to adjust the frequency of the target processor to the target frequency; or the DVFS management module 231 sends response information to the DVFS simple configuration module, where the response information indicates that the frequency of the target processor can be adjusted to the target frequency, and further, the DVFS simple configuration module enables the DVFS. It may be understood that, after the DVFS simple configuration module enables the DVFS, the frequency governor adjusts the frequency of the target processor to the target frequency.

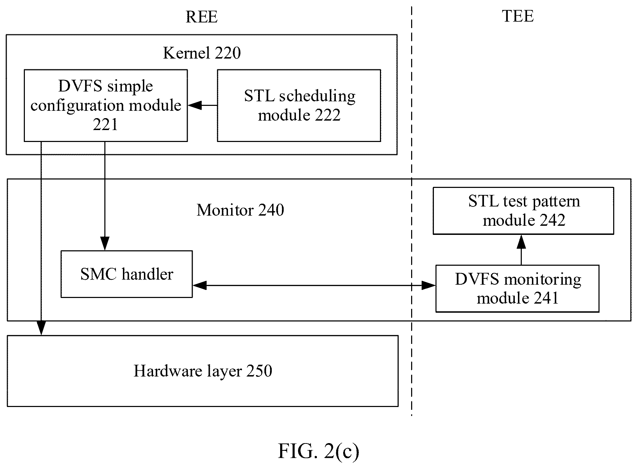

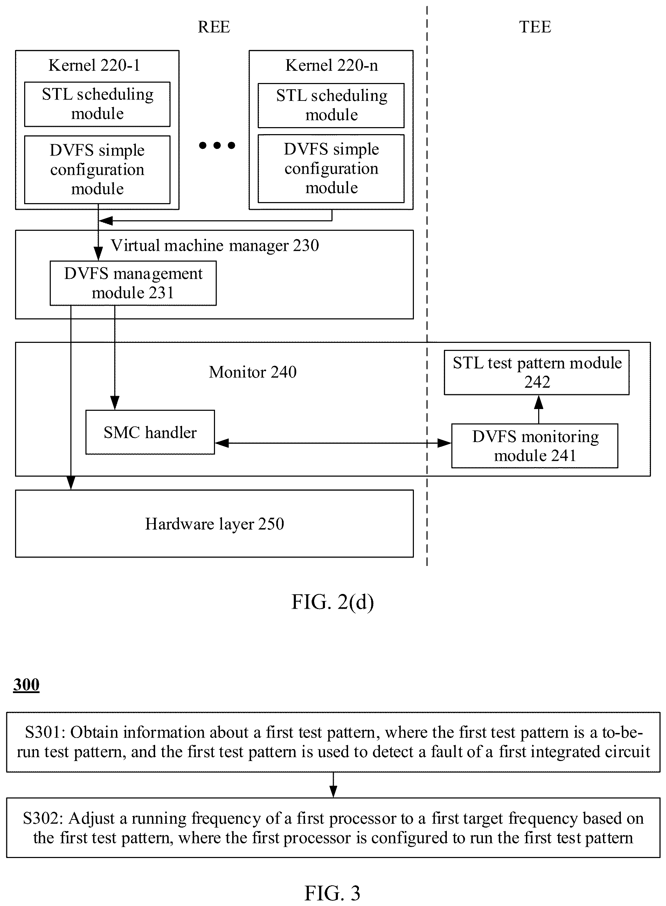

In some implementation scenarios, based on security functions of the hardware, two protection domains with different permission at the processor layer are introduced, namely, a secure world and a normal world. The secure world can provide a trusted execution environment (trusted execution environment, TEE), and the normal world can provide a rich execution environment (rich execution environment, REE). The processor can run in only one environment at any time. The two worlds are completely isolated by hardware and have different permission. An application or an operating system running in the normal world cannot access resources in the secure world, but a program running in the secure world can access resources in the secure world and the normal world. Usually, the STL test pattern is usually run in the TEE, and DVFS-related modules such as the DVFS simple configuration module and the DVFS management module are usually run in the REE. Therefore, the architectures provided in FIG. 2(a) and FIG. 2(b) may respectively evolve into the architectures shown in FIG. 2(c) and FIG. 2(d). In a specific implementation process, a secure monitor call (secure monitor call, SMC) handler (handler) in the monitor 240 may perform world switch based on an instruction of the DVFS simple configuration module 221 for enabling the DVFS, to switch from the REE to the TEE, and performs context switch to run the to-be-run test pattern. In the foregoing scenario, the DVFS monitoring module 241 may be further configured to query, after environment switch is performed, whether world switch succeeds.

It should be understood that the architectures shown in FIG. 2(a) to FIG. 2(d) are merely examples for description. In a specific implementation process, the system shown in FIG. 2(a) to FIG. 2(d) may include more or fewer modules.

Based on the fault detection system shown in FIG. 2(a) to FIG. 2(d), this application provides a fault detection method.

FIG. 3 is a schematic flowchart of a fault detection method according to an embodiment of this application. The method 300 may be performed by the fault detection system shown in FIG. 2(a) to FIG. 2(d), for example, performed by the STL scheduling module 222 shown in FIG. 2(a) to FIG. 2(d), performed by the STL scheduling module 222 and the DVFS simple configuration module 221 shown in FIG. 2(a) to FIG. 2(d), or performed by the STL scheduling module 222, the DVFS simple configuration module 221, and the DVFS management module 231 shown in FIG. 2(a) to FIG. 2(d). The method 300 includes S301 and S302.

S301: Obtain information about a first test pattern, where the first test pattern is a to-be-run test pattern, and the first test pattern is used to detect a fault of a first integrated circuit.

For example, the first integrated circuit is configured to run a target task. The target task may be a running task or a to-be-run task in a system. When the target task is a running task, the target task may be, for example, a running process or thread in the system. For example, when the system is applied to a vehicle and the target task is a process, the target task may be, for example, a vehicle video check process, a vehicle speed calculation process, a radar detection process, a vehicle antilock process, or a tire pressure detection process.

For example, the information about the first test pattern may be used to determine that the first test pattern is the to-be-run test pattern, and the information about the first test pattern may include a scheduling table associated with the target task.

The scheduling table associated with the target task may include one or more test patterns, and the first test pattern may be one of the one or more test patterns. When the target task is a to-be-run task, the first test pattern may be a 1^{st} test pattern that needs to be executed.

S302: Adjust a running frequency of a first processor to a first target frequency based on the first test pattern, where the first processor is configured to run the first test pattern.

For example, the first processor may include the target processor in the foregoing embodiment.

In some implementations, before S302 is performed, frequency optimization information is obtained, where the frequency optimization information indicates a target frequency at which a processor correspondingly runs each of one or more test patterns, and the one or more test patterns include the first test pattern. S302 may be specifically: determining the first target frequency based on the first test pattern and the frequency optimization information.

For example, the frequency optimization information may include the STL frequency optimization information in the foregoing embodiment, or the frequency optimization information may be determined based on a type of the first test pattern. The first target frequency may be the target frequency in the foregoing embodiment. A target frequency of a processor corresponding to a test pattern may be understood as a frequency at which the processor configured to run the test pattern runs the test pattern, where the frequency may make power consumption required for running the test pattern low and/or make a speed of running the test pattern high, and the frequency may include the recommended running frequency in the foregoing embodiment.

In some implementations, the first target frequency is determined based on a running frequency at which the first processor runs the first test pattern last time and running duration of the first test pattern. For example, when the first test pattern is run last time, the DVFS monitoring module 241 records the running frequency of the first processor and the running duration of the first test pattern, and adjusts, based on the running duration of the first test pattern and the type of the first test pattern, the frequency at which the first processor runs the first test pattern.

For example, the frequency optimization information may be shown in Table 1, and may include n test patterns and recommended running frequencies corresponding to the n test patterns, where n is an integer greater than or equal to 3. In some implementations, the frequency optimization information may further include information such as a type of a test pattern, running duration of the test pattern during last running, and a running frequency of a processor during last running of the test pattern. Further, when updating the frequency optimization information, the DVFS monitoring module 241 may update only information in the second column, namely, the recommended running frequency corresponding to the test pattern. Alternatively, if the frequency optimization information includes the information related to the last running of the test pattern, when updating the STL frequency optimization information, the DVFS monitoring module 241 may update the information in the fourth column and the fifth column in Table 1. Specifically, the running frequency of the computing-intensive test pattern 1 last time is 1.2 gigahertz (gigahertz, GHz), and the running duration is 1 millisecond (millisecond, ms). If the running duration of the test pattern 1 can be reduced to 0.5 ms after a limitation on the running frequency of the processor is reduced, the recommended running frequency of the test pattern 1 may be updated to 2.5 GHz. The running frequency of the memory-intensive test pattern 2 last time is 2.5 GHz, and the running duration is 1 ms. If the running duration of the test pattern 2 is not further increased after the running frequency of the processor is reduced, the DVFS monitoring module 241 may update the recommended running frequency of the test pattern 2 to 1.2 GHz. The running frequency of the computing-intensive test pattern n last time is 2.5 GHz, and the running duration is 0.5 ms. If the running duration of the test pattern n is not further reduced after the running frequency of the processor is further increased, the DVFS monitoring module 241 may not modify the recommended running frequency, that is, determine that the recommended running frequency of the test pattern n is 2.5 GHz.

**Table 1**

| STL test pattern | Recommended running frequency | Type of the test pattern | Last running duration | Last running frequency |
|---|---|---|---|---|
| Test pattern 1 | 2.5 GHz | Computing-intensive type | 1 ms | 1.2 GHz |
| Test pattern 2 | 1.2 GHz | Memory-intensive type | 1 ms | 2.5 GHz |
| ... | ... | ... | ... | ... |
| Test pattern n | 2.5 GHz | Computing-intensive type | 0.5 ms | 2.5 GHz |

It should be understood that the form and the related data in Table 1 are merely examples for description. In a specific implementation process, the frequency optimization information may be in another form, and the recommended running frequency of the test pattern may be another value.

For example, the first test pattern may be any one of the test patterns 1 to n in Table 1, and the first target frequency may be a frequency determined based on the recommended running frequency in Table 1.

In some implementations, the first target frequency is determined based on the type of the first test pattern, and the type of the first test pattern includes the computing-intensive type or the memory-intensive type. For example, when the type of the first test pattern is the computing-intensive type, it is determined that the first target frequency is a high frequency; or when the type of the first test pattern is the memory-intensive type, it is determined that the first target frequency is a low frequency.

In some implementations, the first test pattern is associated with a first virtual machine, and after S302 is performed, the method further includes: updating frequency information of a virtual machine manager, where the frequency information indicates a current running frequency of the first processor, and the virtual machine manager is configured to manage one or more virtual machines including the first virtual machine.

For example, that the first test pattern is associated with the first virtual machine may be understood as that the first virtual machine requests to adjust the running frequency of the first processor based on the first test pattern. The frequency information may include the DVFS configuration file in the foregoing embodiment.

In some implementations, when S302 is performed, the first test pattern is run.

In some implementations, before the running frequency of the first processor is adjusted to the first target frequency, first context switch is performed, where the first context switch is used for running of the first test pattern.

For example, that first context switch is performed before the running frequency of the first processor is adjusted to the first target frequency may include: After the DVFS simple configuration module 221 enables DVFS, and before the frequency governor adjusts the running frequency of the first processor to the first target frequency, first context switch is performed; or when the STL scheduling module 222 invokes the DVFS simple configuration module 221, first context switch is performed.

In some implementations, the method further includes: after running of the first test pattern ends and before the running frequency of the first processor is adjusted to a second target frequency, performing second context switch, where the second context switch is used for running of a first process, and the second target frequency is a target frequency at which the first processor correspondingly runs the first process.

For example, the first process may be a running process before the first test pattern is run, and the second target frequency may be a frequency stored when first context switch is performed.

In some implementations, the method further includes: obtaining a second target frequency, where the second target frequency is a frequency that corresponds to the first processor and that is obtained when the target task is run, or the second target frequency is a current running frequency of the first processor; and when the first target frequency is different from the second target frequency, adjusting the running frequency of the processor to the first target frequency.

For example, if the target task is a running task in the system, the second target frequency may alternatively be the running frequency of the first processor that is stored in the DVFS management module.

For another example, if the target task is a to-be-run task, the second target frequency may be determined based on service layer optimization requirement information. The service layer optimization requirement information includes a frequency of a processor required for running each service layer task. For example, the service layer optimization requirement information may be in a form of a file, may be in a form of a table, or may be in another form.

According to the fault detection method provided in embodiments of this application, the running frequency of the processor can be adjusted based on the STL test pattern, so that a running speed of the computing-intensive STL test pattern can be improved, and power consumption required for running the memory-intensive STL test pattern can be reduced. Further, according to the fault detection method provided in embodiments of this application, when the running frequency of the processor is adjusted based on the STL test pattern, frequency adjustment and context switch corresponding to the to-be-run STL test pattern can be simultaneously performed. This helps reduce running duration of the STL test pattern, and reduce impact of the STL test pattern on real-time performance of the service layer task.

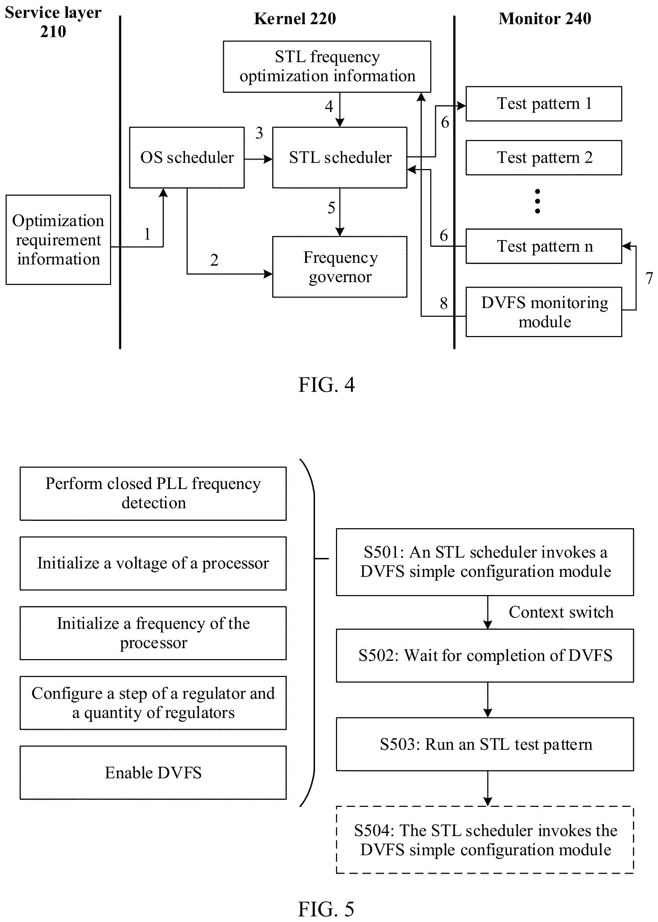

To facilitate understanding of the fault detection method provided in this application, the following further describes the method 300 with reference to FIG. 4 to FIG. 7.

FIG. 4 is a diagram of an application scenario of the fault detection method according to an embodiment of this application. As shown in FIG. 4, to run an STL test pattern, steps 1 to 8 shown in FIG. 4 may need to be performed. Details are as follows:
1: An operating system (operating system, OS) scheduler of a kernel 220 obtains optimization requirement information from a service layer. The optimization requirement information may be the service layer optimization requirement information in the foregoing embodiment.
2: During task switch at the service layer, the OS scheduler controls a frequency governor to adjust a running frequency of a processor.
3: When the STL test pattern needs to be run, the OS scheduler invokes an STL scheduler (STL scheduler). The STL scheduler may be an example of the STL scheduling module 222.
4: The STL scheduler obtains STL frequency optimization information and a scheduling table of a target task, where the scheduling table includes one or more test patterns. The target task may be the target task in the foregoing embodiment.

In some implementations, the STL scheduler determines a to-be-run test pattern n based on a scheduling table. Further, the STL scheduler determines a target frequency of a target processor based on the STL frequency optimization information, where the target processor is configured to run the test pattern n, and the target frequency is a recommended running frequency at which the target processor runs the test pattern n.

The STL frequency optimization information may be considered as an example of the frequency optimization information, the test pattern n may be considered as an example of the first test pattern, the target processor may be considered as an example of the first processor, and the target frequency may be considered as an example of the first target frequency.

In some implementations, the STL frequency optimization information is not stored in the system, but a relationship between a type of a test pattern and a running frequency of a processor is pre-stored in the system. In this case, the STL scheduler determines, based on the type of the test pattern, the target frequency corresponding to the test pattern n.

5: The STL scheduler controls, based on the to-be-run test pattern n, the frequency governor to adjust a running frequency of the target processor to the target frequency.

6: The STL scheduler runs the test pattern n.

In some implementations, if another test pattern, for example, a test pattern 1, is being run before the to-be-run test pattern is run, context switch is performed to run the test pattern n.

In some implementations, if no other test pattern is run before the to-be-run test pattern is run, the test pattern n is directly run.

For example, 6 may be performed after 5, or 5 and 6 may be synchronously performed. When 5 and 6 are synchronously performed, the frequency of the target processor may not be adjusted to the target frequency when the test pattern n starts to be run. Therefore, in a process of running the test pattern n, the target processor may have two running frequencies. For example, a frequency of the processor corresponding to duration before the test pattern n is run is a frequency before frequency adjustment, for example, the second target frequency in the method 300, and a frequency of the processor corresponding to duration after the test pattern n is run is the target frequency.

7: A DVFS monitoring module (for example, the DVFS monitoring module 241) in a monitor 240 monitors a running process of the test pattern n, and obtains the running frequency of the target processor when the test pattern n is run and running duration of the test pattern n.

8: The DVFS monitoring module updates the STL frequency optimization information based on the running frequency of the target processor obtained when the test pattern n is run and the running duration of the test pattern n.

For example, for a specific implementation in which the DVFS monitoring module updates the STL frequency optimization information based on the running frequency and the running duration, refer to the descriptions in the method 300. Details are not described herein again.

With reference to FIG. 5, the following describes a specific implementation in which the frequency of the processor is adjusted and the STL test pattern is run.

FIG. 5 is another diagram of an application scenario of the fault detection method according to an embodiment of this application. As shown in FIG. 5, to enable a target processor to run an STL test pattern at a target frequency, S501 to S503 may be performed.

S501: An STL scheduler invokes a DVFS simple configuration module (for example, the DVFS simple configuration module 221).

The DVFS simple configuration module may perform the following steps: performing closed phase-locked loop (phase-locked loop, PLL) frequency detection, initializing a voltage of a processor, initializing a frequency of the processor, configuring a step of a regulator and a quantity of regulators (regulator), and enabling DVFS. After DVFS is enabled, the frequency of the processor starts to be adjusted.

Context switch is performed when or after the step of enabling DVFS is completed.

S502: Wait for completion of DVFS.

Waiting for completion of DVFS may be understood as waiting for adjusting the frequency of the processor to a target frequency, for example, a first target frequency.

S503: Run an STL test pattern.

For example, when or after switching to a layer at which a monitor 240 is located to wait for completion of DVFS, the STL scheduler runs the STL test pattern, for example, a first test pattern.

For another example, when or after waiting for completion of DVFS, the STL scheduler switches to the layer at which the monitor 240 is located to run the STL test pattern.

For still another example, after context switch is completed, the STL test pattern is directly run. If duration required for context switch is longer than duration required for frequency conversion, the STL test pattern is run in a process of waiting for completion of DVFS.

It may be understood that, in a process of adjusting the frequency of the processor, both the step of waiting for completion of DVFS after DVFS is enabled and the process of performing context switch are time-consuming. In this application, context switch is performed in the process of waiting for completion of DVFS, duration required for running the STL process can be shortened.

In some possible implementations, when running of the STL test pattern ends, S504 and S505 may be further performed.

S504: The STL scheduler invokes the DVFS simple configuration module.

For example, after the running of the STL test pattern ends, if the running frequency of the processor that is stored before the context switch needs to be restored, S504 is performed. Specifically, the steps performed by DVFS are described in S501. Details are not described herein again. When or after the step of enabling DVFS is completed, context switch is performed. To be specific, in the process of waiting for completion of DVFS, context switch is performed to run a next process.

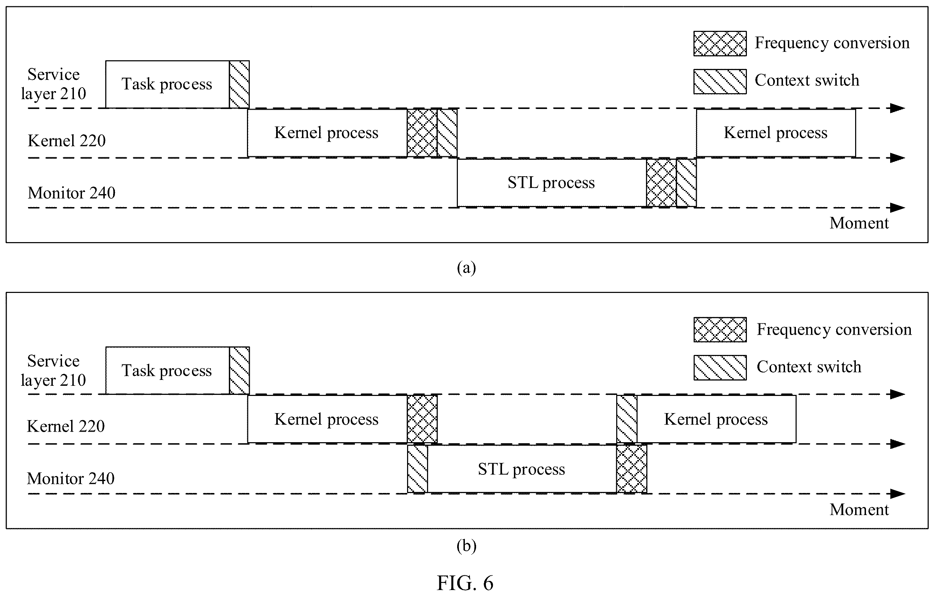

(a) and (b) in FIG. 6 respectively show time sequence diagrams of execution of processes that does not use the method in this application and execution of processes that uses the method in this application. It can be learned that, when the method in this application is not used, context switch needs to be performed after frequency conversion is completed. Therefore, it is clear that duration required for switching between a kernel process and an STL process is greater than duration required for switching between a kernel process and an STL process that uses the method in this application. The frequency conversion may be understood as waiting for end of DVFS, namely, duration from time at which DVFS is enabled to time at which DVFS is completed.

In some possible implementations, when the STL test pattern is a test pattern running in a TEE, before context switch is performed, an REE further needs to be switched to the TEE, to adjust a running frequency of a processor based on the STL test pattern running in the TEE.

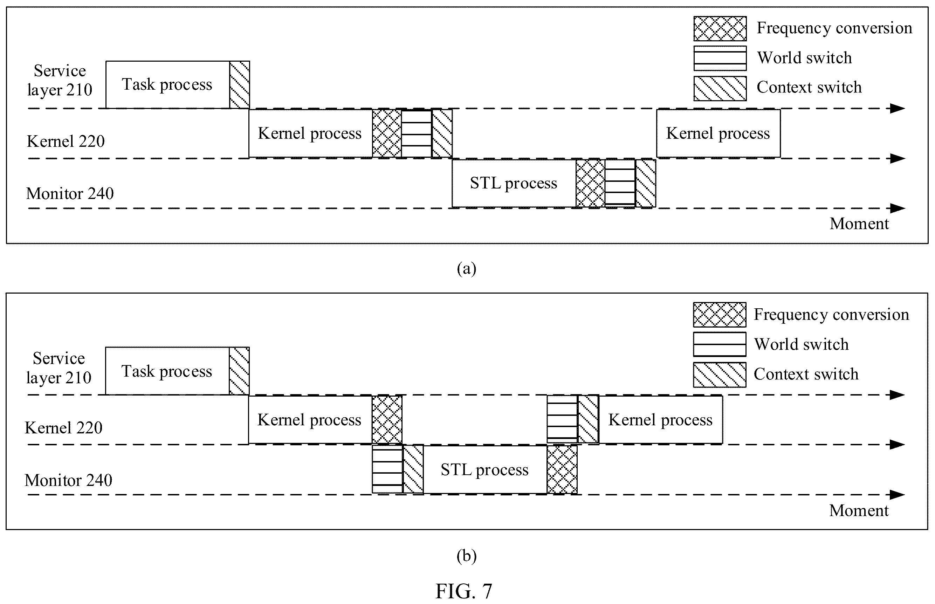

(a) and (b) in FIG. 7 respectively show time sequence diagrams of execution of processes that does not use the method in this application and execution of processes that uses the method in this application. It can be learned that, when the method in this application is not used, context switch needs to be performed after frequency conversion and world switch are sequentially completed. Therefore, it is clear that duration required for switching between a kernel process and an STL process is greater than duration required for switching between a kernel process and an STL process that uses the method in this application. The world switch may be understood as switch between an REE and a TEE.

It is found through verification that when a fully running STL is used to perform fault detection on 10 service layer tasks (including computing-intensive and memory-intensive tasks) in an intelligent driving system, duration required for STL-based fault detection performed once is 4.205 ms. However, when a fault detection algorithm provided in this application is used to perform fault detection on the same 10 service layer tasks, duration required for STL-based fault detection performed once is 3.525 ms. In other words, running duration of the STL test pattern is shortened by about 17% compared with that in the existing fault detection technology.

In embodiments of this application, unless otherwise stated or there is a logic conflict, terms and/or descriptions in embodiments are consistent and may be mutually referenced, and technical features in different embodiments may be combined based on an internal logical relationship thereof, to form a new embodiment.

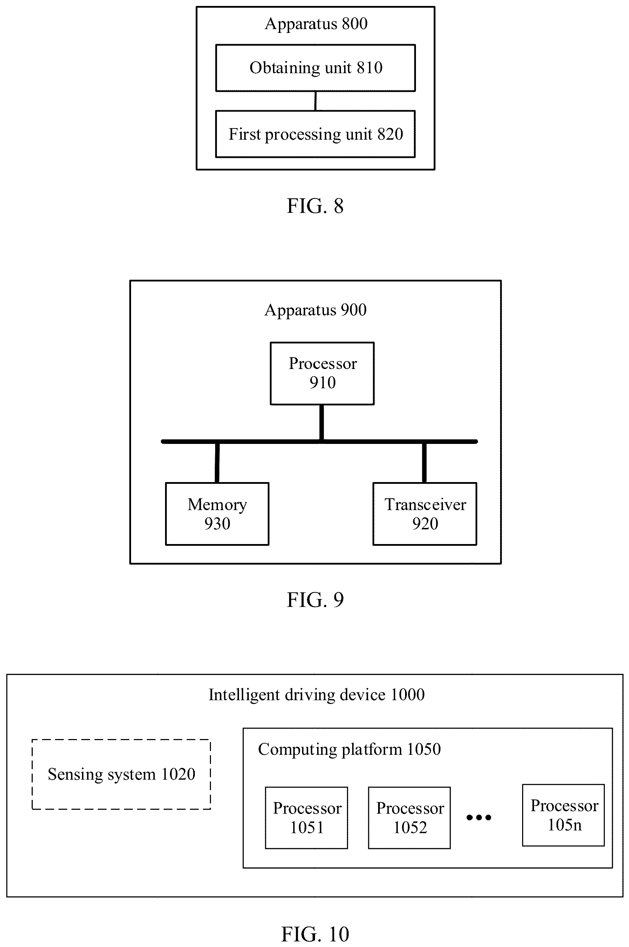

The fault detection method provided in embodiments of this application is described above in detail with reference to FIG. 2(a) to FIG. 2(d) to FIG. 7. A fault detection apparatus provided in embodiments of this application is described below in detail with reference to FIG. 8 and FIG. 9. It should be understood that descriptions of control apparatus embodiments correspond to the descriptions of the method embodiments. Therefore, for content that is not described in detail, refer to the foregoing method embodiments. For brevity, details are not described herein again.

FIG. 8 is a block diagram of a fault detection apparatus 800 according to an embodiment of this application. The apparatus 800 may include units configured to perform the method in FIG. 3. In addition, the units in the apparatus 800 are configured to implement the corresponding procedure in the method embodiment in FIG. 3.

Specifically, the apparatus 800 includes an obtaining unit 810 and a first processing unit 820. The obtaining unit 810 is configured to obtain information about a first test pattern, where the first test pattern is a to-be-run test pattern, and the first test pattern is used to detect a fault of a first integrated circuit; and the first processing unit 820 is configured to adjust a running frequency of a first processor to a first target frequency based on the first test pattern, where the first processor is configured to run the first test pattern.

In some implementations, the first target frequency is determined based on a type of the first test pattern, and the type of the first test pattern includes a computing-intensive type or a memory-intensive type.

In some implementations, the first target frequency is determined based on a running frequency at which the first processor runs the first test pattern last time and running duration of the first test pattern.

In some implementations, the first test pattern is associated with a first virtual machine, and the apparatus 800 further includes a second processing unit, configured to: after the running frequency of the first processor is adjusted to the first target frequency, update frequency information of a virtual machine manager, where the frequency information indicates a current running frequency of the first processor, and the virtual machine manager is configured to manage one or more virtual machines including the first virtual machine.

In some implementations, the obtaining unit 810 is further configured to obtain frequency optimization information, where the frequency optimization information indicates a target frequency at which a processor correspondingly runs each of one or more test patterns, and the one or more test patterns include the first test pattern; and the first processing unit 820 is configured to determine the first target frequency based on the first test pattern and the frequency optimization information.

In some implementations, the first processing unit 820 is further configured to run the first test pattern when the running frequency of the first processor is adjusted.

In some implementations, the first processing unit 820 is further configured to: before the running frequency of the first processor is adjusted to the first target frequency, perform first context switch, where the first context switch is used for running of the first test pattern.

In some implementations, the first processing unit 820 is further configured to: after running of the first test pattern ends and before the running frequency of the first processor is adjusted to a second target frequency, perform second context switch, where the second context switch is used for running of a first process, and the second target frequency is a target frequency at which the first processor correspondingly runs the first process.

In some implementations, when the first test pattern is associated with a trusted execution environment TEE, before performing first context switch, the apparatus 800 further includes a third processing unit, configured to switch from a rich execution environment REE to the TEE.

For example, the apparatus 800 may be disposed in the system shown in any one of FIG. 2(a) to FIG. 2(d). More specifically, the obtaining unit 810 may include the STL scheduling module 222 (or the STL scheduling module) shown in FIG. 2(a) to FIG. 2(d), and the first processing unit 820 may include the STL scheduling module 222 (or the STL scheduling module) shown in FIG. 2(a) to FIG. 2(d). In some implementations, the first processing unit 820 may further include the DVFS simple configuration module 221 (or the DVFS simple configuration module) shown in FIG. 2(a) to FIG. 2(d). For example, the second processing unit may include the DVFS management module 231 shown in FIG. 2(a) to FIG. 2(d), and the third processing unit may include the SMC handler shown in FIG. 2(a) to FIG. 2(d).

For example, the operations performed by the obtaining unit 810 and the first processing unit 820 may be performed by one processor, or may be performed by different processors. In a specific implementation process, the one or more processors may be processors disposed in an intelligent driving device. Alternatively, the apparatus 800 may be a chip disposed in the intelligent driving device.

In this embodiment of this application, the processor is a circuit having a signal processing capability. In an implementation, the processor may implement a specific function by using a logical relationship of a hardware circuit. The logical relationship of the hardware circuit is fixed or reconfigurable. For example, the processor is an application-specific integrated circuit (application-specific integrated circuit, ASIC) or a hardware circuit implemented by a programmable logic device (programmable logic device, PLD), for example, a field programmable gate array (field programmable gate array, FPGA). In the reconfigurable hardware circuit, a process in which the processor loads a configuration document to implement configuration of the hardware circuit may be understood as a process in which the processor loads instructions to implement functions of some or all of the units. In addition, the processor may alternatively be a hardware circuit designed for artificial intelligence, and may be understood as an ASIC, for example, a neural-network processing unit (neural-network processing unit, NPU), a tensor processing unit (tensor processing unit, TPU), or a deep learning processing unit (deep learning processing unit DPU).

In a specific implementation process, all or some of the units in the foregoing apparatus may be integrated together, or may be implemented independently. In an implementation, these units are integrated together and implemented in a form of a system-on-a-chip (system-on-a-chip, SoC).

FIG. 9 is another block diagram of a fault detection apparatus according to an embodiment of this application. The fault detection apparatus 900 shown in FIG. 9 may include a processor 910, a transceiver 920, and a memory 930. The processor 910, the transceiver 920, and the memory 930 are connected through an internal connection path. The memory 930 is configured to store instructions. The processor 910 is configured to execute the instructions stored in the memory 930, to implement the methods in the foregoing embodiments. Optionally, the memory 930 may be coupled to the processor 910 through an interface, or may be integrated together with the processor 910.

It should be noted that the transceiver 920 may include but is not limited to a transceiver apparatus like an input/output interface (input/output interface), to implement communication between the apparatus 900 and another device or a communication network.

The memory 930 may be a volatile memory and/or a nonvolatile memory. The nonvolatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM). For example, the RAM may be used as an external cache. By way of example, but not limitation, the RAM includes a plurality of forms, such as a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM).

The transceiver 920 uses, for example, but is not limited to, a transceiver apparatus of a transceiver type, to implement communication between the apparatus 910 and another device or a communication network, to receive/send data/information used to implement the methods in the foregoing embodiments.

An embodiment of this application further provides a computing platform. The computing platform includes the fault detection apparatus 800 or the fault detection apparatus 900 in the foregoing embodiments.

An embodiment of this application further provides an intelligent driving device. The intelligent driving device includes the fault detection apparatus 800 or the fault detection apparatus 900 in the foregoing embodiments.

The intelligent driving device in this embodiment of this application may include a land transportation means, a water transportation means, an air transportation means, an industrial device, an agricultural device, an entertainment device, or the like. For example, the intelligent driving device may be a vehicle. The vehicle is a vehicle in a broad sense, and may be a transportation means (for example, a commercial vehicle, a passenger vehicle, a motorcycle, an airborne vehicle, or a train), an industrial vehicle (for example, a forklift truck, a trailer, or a tractor), an engineering vehicle (for example, an excavator, a bulldozer, or a crane), an agricultural device (for example, a lawn mower or a harvester), a recreational device, a toy vehicle, or the like. A type of the vehicle is not specifically limited in embodiments of this application.

FIG. 10 is a block diagram of an intelligent driving device according to an embodiment of this application. As shown in FIG. 10, the intelligent driving device 1000 includes a computing platform 1050, and the computing platform 1050 may include processors 1051 to 105n. For example, the processors 1051 to 105n may be, for example, a CPU, a microprocessor, a GPU, or a digital signal processor (digital signal processor, DSP). The computing platform 1050 may be considered as an example of the computing platform in the foregoing embodiments. The apparatus 800 or the apparatus 900 may be disposed in one or more processors of the computing platform 1050. Optionally, the intelligent driving device 1000 may further include a sensing system 1020. The sensing system 1020 may include several sensors configured to obtain image information around the intelligent driving device. For example, the sensing system 1020 may include a sensor that can obtain image information, for example, a lidar or a camera apparatus. The image information obtained by the sensing system 1020 may be input to the computing platform 1050 for processing, and the computing platform 1050 may accelerate an image processing speed based on a data processing method provided in this application.

For example, the intelligent driving device is a vehicle. The computing platform may include any one of the following: a vehicle domain controller (vehicle domain controller, VDC), an advanced driving domain controller (advanced driving domain controller, ADC), and a cockpit domain controller (cockpit domain controller, CDC). For another example, the computing platform may further include but is not limited to an in-car application-server (in-car application-server, ICAS) controller, a body domain controller (body domain controller, BDC), a special equipment system (special equipment system, SAS), a media graphics unit (media graphics unit, MGU), a body super core (body super core, BSC), and an advanced driver-assistance system super core (advanced driver-assistance system super core, ADAS super core). The ICAS may include at least one of the following: a vehicle control server ICAS 1, an intelligent driving server ICAS 2, an intelligent cockpit server ICAS 3, and an infotainment server ICAS 4.

An embodiment of this application further provides a computer program product. The computer program product includes computer program code. When the computer program code is run on a computer, the computer is enabled to implement the methods in the foregoing embodiments of this application.

An embodiment of this application further provides a computer-readable storage medium. The computer-readable medium stores computer instructions. When the computer instructions are run on a computer, the computer is enabled to implement the methods in the foregoing embodiments of this application.

An embodiment of this application further provides a chip, including a circuit, configured to perform the methods in the foregoing embodiments of this application.

It may be clearly understood by a person skilled in the art that, for ease and brevity of description, for a detailed working process of the foregoing system, apparatus, and unit, refer to a corresponding process in the foregoing method embodiments. Details are not described herein again.

In the descriptions of embodiments of this application, "/" means "or" unless otherwise specified. For example, A/B may indicate A or B. In this specification, "and/or" describes an association relationship between associated objects and indicates that three relationships may exist. For example, A and/or B may indicate the following three cases: Only A exists, both A and B exist, and only B exists. In this application, "at least one" means one or more, and "a plurality of" means two or more. "At least one of the following items (pieces)" or a similar expression thereof indicates any combination of these items, including a single item (piece) or any combination of a plurality of items (pieces). For example, at least one item (piece) of a, b, or c may indicate a, b, c, a and b, a and c, b and c, or a, b, and c, where a, b, and c may be singular or plural.

In embodiments of this application, prefix words such as "first" and "second" are used only to distinguish between different described objects, and do not limit locations, a sequence, priorities, quantities, content, or the like of the described objects. Use of prefix words such as ordinal numbers used to distinguish between the described objects in embodiments of this application does not constitute a limitation on the described objects. For descriptions of the described objects, refer to the context descriptions in the claims or embodiments. The use of such prefix words should not constitute a redundant limitation.

In the several embodiments provided in this application, it should be understood that the disclosed system, apparatus, and method may be implemented in other manners. For example, the described apparatus embodiment is merely an example. For example, division into the units is merely logical function division and may be other division in an actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in an electronic form, a mechanical form, or another form.

In embodiments of this application, unless otherwise stated or there is a logic conflict, terms and/or descriptions in embodiments are consistent and may be mutually referenced, and technical features in different embodiments may be combined based on an internal logical relationship thereof, to form a new embodiment.

The units described as separate components may or may not be physically separate, and components displayed as units may or may not be physical units, may be located in one position, or may be distributed on a plurality of network units. Some or all of the units may be selected based on actual requirements to achieve the objectives of the solutions of embodiments.

In addition, functional units in embodiments of this application may be integrated into one processing unit, each of the units may exist alone physically, or two or more units may be integrated into one unit.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A fault detection method, comprising:
obtaining information about a first test pattern, wherein the first test pattern is a to-be-run test pattern, and the first test pattern is used to detect a fault of a first integrated circuit; and
adjusting a running frequency of a first processor to a first target frequency based on the first test pattern, wherein the first processor is configured to run the first test pattern.

2. The method according to claim 1, wherein the first target frequency is determined based on a type of the first test pattern, and the type of the first test pattern comprises a computing-intensive type or a memory-intensive type.

3. The method according to claim 1 or 2, wherein the first target frequency is determined based on a running frequency at which the first processor runs the first test pattern last time and running duration of the first test pattern.

4. The method according to any one of claims 1 to 3, wherein the first test pattern is associated with a first virtual machine, and the method further comprises:
after the running frequency of the first processor is adjusted to the first target frequency, updating frequency information of a virtual machine manager, wherein the frequency information indicates a current running frequency of the first processor, and the virtual machine manager is configured to manage one or more virtual machines comprising the first virtual machine.

5. The method according to any one of claims 1 to 4, wherein the method further comprises:
obtaining frequency optimization information, wherein the frequency optimization information indicates a target frequency at which a processor correspondingly runs each of one or more test patterns, and the one or more test patterns comprise the first test pattern; and
determining the first target frequency based on the first test pattern and the frequency optimization information.

6. The method according to any one of claims 1 to 5, wherein the method further comprises:
running the first test pattern when the running frequency of the first processor is adjusted.

7. The method according to any one of claims 1 to 6, wherein the method further comprises:
before the running frequency of the first processor is adjusted to the first target frequency, performing first context switch, wherein the first context switch is used for running of the first test pattern.

8. The method according to claim 7, wherein the method further comprises:
after running of the first test pattern ends and before the running frequency of the first processor is adjusted to a second target frequency, performing second context switch, wherein the second context switch is used for running of a first process, and the second target frequency is a target frequency at which the first processor correspondingly runs the first process.

9. The method according to claim 7 or 8, wherein when the first test pattern is associated with a trusted execution environment TEE, before performing first context switch, the method further comprises:
switching from a rich execution environment REE to the TEE.

10. A fault detection apparatus, comprising:
an obtaining unit, configured to obtain information about a first test pattern, wherein the first test pattern is a to-be-run test pattern, and the first test pattern is used to detect a fault of a first integrated circuit; and
a first processing unit, configured to adjust a running frequency of a first processor to a first target frequency based on the first test pattern, wherein the first processor is configured to run the first test pattern.

11. The apparatus according to claim 10, wherein the first target frequency is determined based on a type of the first test pattern, and the type of the first test pattern comprises a computing-intensive type or a memory-intensive type.

12. The apparatus according to claim 10 or 11, wherein the first target frequency is determined based on a running frequency at which the first processor runs the first test pattern last time and running duration of the first test pattern.

13. The apparatus according to any one of claims 10 to 12, wherein
the first test pattern is associated with a first virtual machine, and the apparatus further comprises a second processing unit, configured to:
after the running frequency of the first processor is adjusted to the first target frequency, update frequency information of a virtual machine manager, wherein the frequency information indicates a current running frequency of the first processor, and the virtual machine manager is configured to manage one or more virtual machines comprising the first virtual machine.

14. The apparatus according to any one of claims 10 to 13, wherein the obtaining unit is further configured to:
obtain frequency optimization information, wherein the frequency optimization information indicates a target frequency at which a processor correspondingly runs each of one or more test patterns, and the one or more test patterns comprise the first test pattern; and
the first processing unit is configured to:
determine the first target frequency based on the first test pattern and the frequency optimization information.

15. The apparatus according to any one of claims 10 to 14, wherein the first processing unit is further configured to:
run the first test pattern when the running frequency of the first processor is adjusted.

16. The apparatus according to any one of claims 10 to 15, wherein the first processing unit is further configured to:
before the running frequency of the first processor is adjusted to the first target frequency, perform first context switch, wherein the first context switch is used for running of the first test pattern.

17. The apparatus according to claim 16, wherein the first processing unit is further configured to:
after running of the first test pattern ends and before the running frequency of the first processor is adjusted to a second target frequency, perform second context switch, wherein the second context switch is used for running of a first process, and the second target frequency is a target frequency at which the first processor correspondingly runs the first process.

18. The apparatus according to claim 16 or 17, wherein when the first test pattern is associated with a trusted execution environment TEE, before performing first context switch, the apparatus further comprises a third processing unit, configured to:
switch from a rich execution environment REE to the TEE.

19. A fault detection apparatus, comprising:
a memory, configured to store a computer program; and
a processor, configured to execute the computer program stored in the memory, to enable the apparatus to perform the method according to any one of claims 1 to 9.

20. An intelligent driving device, wherein the intelligent driving device comprises the apparatus according to any one of claims 10 to 19.

21. A computer-readable storage medium, wherein the computer-readable storage medium stores instructions, and when the instructions are executed by a processor, the processor is enabled to implement the method according to any one of claims 1 to 9.

22. A chip, wherein the chip comprises a circuit, and the circuit is configured to perform the method according to any one of claims 1 to 9.
